# EUROPEAN PATENT APPLICATION

(11) **EP 3 996 093 A1**
(43) Date of publication of application: **11.05.2022**
(21) Application number: 20290075.9
(22) Date of filing: 06.11.2020
(51) Int. Cl.: G11C 11/16

(54) **MAGNETIC RANDOM ACCESS MEMORY CELL AND METHOD FOR WRITING AND READING SUCH MEMORY ELEMENT**

(71) Applicant: Antaios SAS, 38330 Montbonnot-Saint-Martin (FR)
(72) Inventor: BRUN-PICARD, Jérémy, 1950 Sion (CH); DROUARD, Marc, 26000 Valence (FR); MARTIN, Sylvain, 38100 Grenoble (FR)
(74) Representative: Wenger, Joel-Théophile

(57) **Abstract**

The present disclosure is about a magnetic random access memory (MRAM) cell (100), comprising a first magnetic tunnel junction (MTJ) element (10) comprising a tunnel barrier layer (22) between a reference layer (21) having a reference magnetization and a free layer (23) having a free magnetization that can be freely oriented, the reference and free layers (21, 23) having a perpendicular magnetic anisotropy (PMA); a SOT current layer (30) configured to pass a write current (301) adapted for switching the free magnetization by a spin current by SOT interaction. The MRAM cell (100) further comprises an electrostatic gate (50) configured to electrostatically interact with a semiconductor layer (40) disposed in direct contact to the SOT current layer 30 such that the semiconductor layer resistance can be modulated for read and/or write process.

## Description

### Technical domain

The present invention relates to a magnetic memory element that is switchable by applying a writing current using a spin orbit torque (SOT) interaction.

### Related art

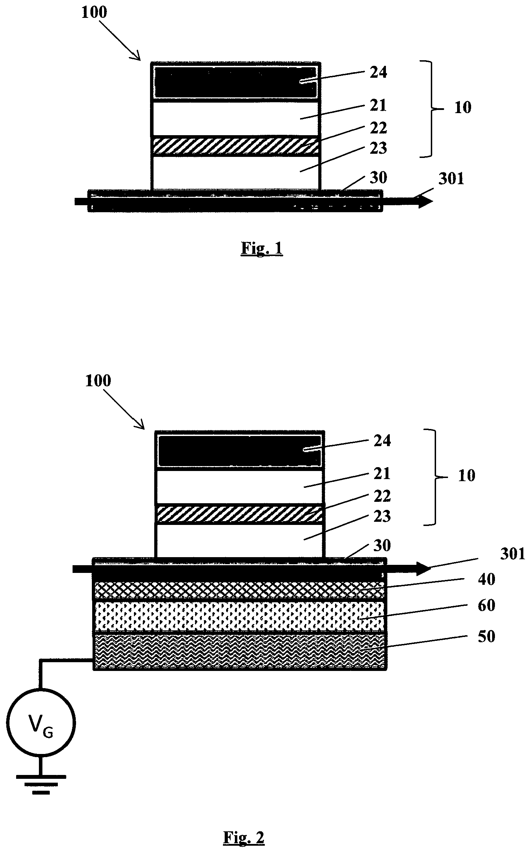

The documents WO2012014131 and WO2012014132 disclose the structure of a memory cell of a so-called SOT magneto resistive memory device. Fig.1 shows an example of a magnetic random access memory (MRAM) cell 100 comprising a magnetic tunnel junction (MTJ) element 10 comprising a tunnel barrier 22 sandwiched between a reference layer 21 having a fixed magnetization and a free layer 23 having a magnetization that can be switched between two directions. The free layer can have a magnetization parallel to the fixed layer or anti-parallel to the fixed layer. The two ferromagnetic layers 21 and 23 can exhibit a perpendicular magnetic anisotropy (PMA) leading to a magnetization perpendicular to a plane formed by the layers (out-of-plane) or an in-plane magnetic anisotropy leading to a magnetization extending in a plane formed by the layers. The ferromagnetic layers 21 and 23 can comprise any material from the list: Fe, Co, Ni, FeCo, CoNi, CoFeB, FeB, FePt, FePd or other suitable ferromagnetic material. The tunnel barrier 22 can comprise MgO, Al₂O₃ or other suitable materials.

The MRAM cell 100 also comprises a capping layer 24 that can be composed of an electrically conductive layer or a synthetic anti-ferromagnetic (SAF) layer or a structure including a metallic non-magnetic spacer layer and a ferromagnetic layer.

The MRAM cell 100 further comprises a SOT current layer 30 disposed at one end of the MTJ 10 in contact with the free layer 23. The SOT current layer is made of conductive heavy metal layer such has Ta, Bi, Pt, W, Ir, Ru, Pd, Cu, Au, Bi, Hf, Se, Sb or of an alloy of these elements or other suitable metal materials. When the charge current 301 is flowing through the SOT current layer, a spin current is generated by spin orbit interaction for example by spin Hall effect and/or Rashba-Edelstein effect. This pure spin current flows through the free layer 23 and is able to switch the magnetization. The magnetization can for example change from parallel to antiparallel to the fixed magnetization.

### Object of the invention

The object of the present disclosure is to propose a solution to improve the accuracy of the reading into a memory cell for a given time. For a given read time, a better accuracy can be achieved by having a MTJ resistance significantly higher than the rest of the electrical circuit. Conversely the present solution also decreases the time duration for reading a memory cell.

Because the lost electrical power P is P=RI², decreasing the resistance R of the electrical circuit allows having less energy loss during the reading for a given current intensity I. The loss is due to the resistance of the conductive layer therefore decreasing the resistance is reducing the energy necessary for reading the memory cell as well as improving the accuracy.

This solution has several other advantages for example concentrates the writing current in the SOT current layer to ensure high spin-charge conversion efficiency. It is especially useful in the case of differential bitcell where the SOT current layer is longer than 40 nm and more generally for SOT MRAM with a long SOT current layer.

The present disclosure is about a MRAM cell, comprising a first magnetic tunnel junction (MTJ) element comprising a tunnel barrier layer between a reference layer having a reference magnetization and a free layer having a magnetization that can be freely oriented. The MRAM cell further comprises a SOT current layer configured to pass a write current substantially parallel to the plane of the free layer and adapted for switching the free magnetization.

In order to achieve the proposed aim, a semiconductor layer separated from an electrostatic gate by an insulating layer is added below the MTJ. Applying a voltage to the electrostatic gate has the consequence to modify *i.e.* increase or decrease the resistance of the semiconductor layer by electrostatic coupling.

### Brief description of the figures

Exemplar embodiments of the invention are disclosed in the description and illustrated by the drawings in which:
Fig. 1 shows a MRAM cell comprising a tunnel barrier layer, a reference layer, a free layer and a current layer;
Fig. 2 represents a MRAM cell comprising a semiconductor layer and an electrostatic gate, during the writing, according to an embodiment;
Fig. 3 represents a MRAM cell comprising a semiconductor layer and an electrostatic gate, during the reading, according to an embodiment;
Fig. 4 represents a MRAM cell comprising a semiconductor layer and an electrostatic gate, according to an embodiment;
Fig. 5 represents a partial view of the MRAM cell comprising a free layer a semiconductor layer and an electrostatic gate according to an embodiment;

### Detailed description

### General description of the magneto resistive memory cell

The figure 1 represents the MRAM cell of the prior art.

With reference to figure 2, a MRAM cell 100 comprising a magnetic tunnel junction (MTJ) element 10 composed of a tunnel barrier 22 sandwiched between a reference layer 21 having a fixed magnetization and a free layer 23 having a magnetization that can be switched between two directions. The free layer can have a magnetization parallel to the fixed layer or anti-parallel to the fixed layer. The two ferromagnetic layers 21 and 23 can exhibit a perpendicular magnetic anisotropy (PMA) leading to a magnetization perpendicular to a plane formed by the layers (out-of-plane) or an in-plane magnetic anisotropy leading to a magnetization extending in a plane formed by the layers.

The MRAM cell 100 further comprises a SOT current layer 30 disposed at one end of the MTJ 10 in contact with the free layer 23. When the charge current 301 is flowing through the SOT current layer, a spin current is generated by spin orbit interaction for example by spin Hall effect and/or Rashba-Edelstein effect. This pure spin current flow through the free layer 23 and is able to switch the magnetization. The magnetization can for example change from parallel to antiparallel to the fixed magnetization. The SOT current layer 30 can comprise any material from the list: Ta, Bi, Pt, W, Ir, Ru, Pd, Cu, Au, Bi, Hf, Se, Sb or of an alloy of these elements. The SOT current layer 30 presents a thickness that may range between 0.5 nm and 200 nm, more particularly between 0.5 nm to 5 nm.

The ferromagnetic layers 21 and 23 can comprise any material from the list: FePt, FePd, CoPt, a rare earth/transition metal alloy, such as GdCo, TdFeCo, Co, Fe, CoFe, Ni, CoNi, CoFeB, FeB, or magnetic Heusler alloys such as CoFeAlSi, Co₂FeSi, CoFeCrAl, Co₂MnSi or other suitable ferromagnetic materials. The thickness of the free layer 23 can be between 0.5 nm and 10 nm and preferably between 1 and 3 nm.

The tunnel barrier 22 can comprise MgO, Al2O3 or other suitable materials.

The MRAM cell 100 can further comprise a capping layer 24, possibly including an antiferromagnetic layer exchange coupling the reference layer such as to pin the magnetization in a predetermined direction. Alternatively, The MRAM cell 100 can comprise a SAF structure with the reference layer 21. The SAF structure 24 can comprise a metallic non-magnetic spacer layer and a ferromagnetic layer.

The MRAM cell 100 can further comprise an electrostatic gate with an insulating layer as well as a semiconductor layer whose resistance can vary. This layer makes it possible to circulate the reading and writing current in the desired path.

For writing the memory, the electrostatic gate changes the Fermi level inside the semiconductor layer and therefore modulates the resistance to generate a spin current with the greatest possible efficiency.

For reading the memory, the resistance of the entire MTJ plus the rest of the electrical circuit is measured. The electrostatic gate changes the Fermi level inside the semiconductor layer and therefore adds more charge carrier, decreasing the semiconductor resistance. By decreasing the semiconductor resistance the total resistance decreases and therefore the relative value of the MTJ resistance increases allowing a better accuracy for a given time.

### 1^{st} embodiment:

**Fig. 2** shows a MRAM cell 100 according to a first embodiment in which the semiconductor layer 40 is directly located below the SOT current layer 30. The semiconductor layer can be any semiconductor such as: silicon carbide, gallium arsenic, gallium phosphide, indium phosphide, indium arsenide, and/or indium antimonide; an alloy semiconductor including SiGe, GaAsP, AlInAs, AIGaAs, GaInAs, GalnP, and/or GaInAsP; or combinations thereof. It can also be a 2D material such as graphene, WSe2, WeSe2.

An electrostatic gate 50 is positioned below the semiconductor layer 40 at a distance between 0.1 nm and 100 nm and preferably between 1 nm and 20 nm. The electrostatic gate material can comprise, but is not limited to: Au, Cu, Ag, Pb, Zn, Al, W, Ta, Mo, Pt, Pd, Si, Co, Fe, Ni or any alloy.

The SOT current layer 30 and the semiconductor layer 40 could have the same shape to have a homogenous effect on the entire current path. The electrostatic gate 50 can have the same shape or a different one; depending on the architecture of the memory this electrostatic gate 50 can be shared for several MRAM cells 100.

The semiconductor layer 40 and the electrostatic gate 50 are electrically insulated from each other by an insulating layer 60. The electrical isolation can be done by any insulating material and particularly dielectric material with a high dielectric constant (high-k) such as any materials from the list: HfSiO₄, ZrSiO₄, HfO₂, ZrO₂, MgO. It can also be an insulating layer comprising any materials such as SiO₂, Al₂O₃.

The electrostatic gate 50 is electrically connected to a voltage generator. The voltage generator applies a bias voltage V_{G} to the electrostatic gate 50. The electrostatic gate 50 is configured to generate an electric field E_{G} able to change the Fermi level inside the semiconductor layer 40. The Fermi level of the semiconductor layer will change and as well as the number of charge carrier. By this mean the resistance can be modulated. During the writing process the semiconductor layer 40 can exhibit a high resistance. This allows the write current 301 to flow through the SOT current layer 30 and insure high current charge-spin conversion efficiency. The resistance of the semiconductor layer 40 can be higher than 50% of the SOT current layer 30 resistance.

The bias voltage V_{G} should be such that the electric field E_{G} is between 0.1kV/cm and 1MV/cm and preferably between 1 kV/cm and 100 kV/cm or between 5 and 20 kV/cm.

The bias voltage V_{G} can be set to a fixed value for example applied during a duration being equal or greater than the duration of the passing writing current 301. For example, the duration of the writing current 301 pulse can be between 0.01 ns and 100 ns and preferably between 0.1 ns and 10 ns.

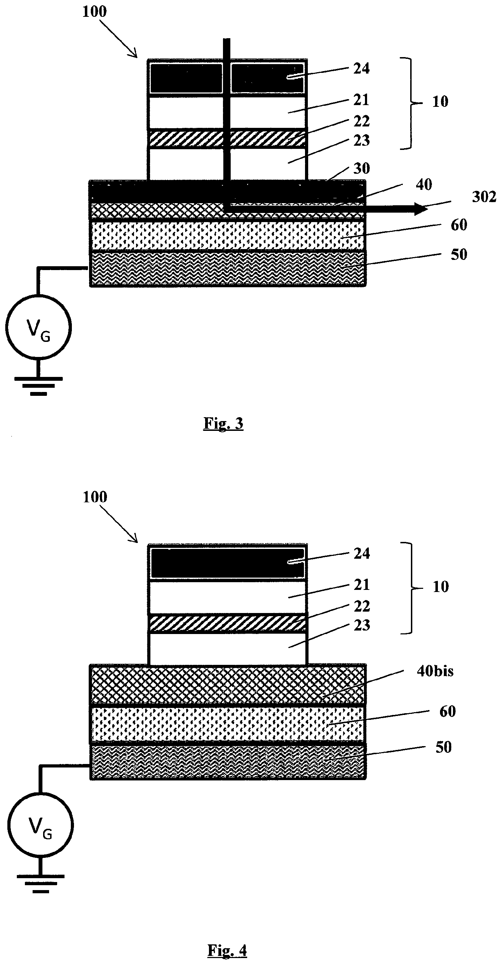

**Fig. 3** presents the same MRAM cell 100 during the reading process. By applying a voltage V_{G} to the electrostatic gate 50 the resistance of the semiconductor layer 40 can be lower than the SOT current layer 30. The resistance of the semiconductor layer 40 can be lower than 50% of the SOT current layer 30 resistance. The reading current 302 flows through the MTJ 10 and a small portion of the SOT current layer 30 and then in the semiconductor layer 40. Decreasing the resistance along the reading current path allow a more accurate reading for a given time.

The bias voltage V_{G} should be such that the electric field E_{G} is between 0.1kV/cm and 1MV/cm and preferably between 1 kV/cm and 100 kV/cm or between 5 and 20 kV/cm.

The bias voltage V_{G} can be for example applied during a duration being equal or greater than the duration of the passing reading current 302. For example, the duration of the reading current 302 pulse can be between 0.01 ns and 100 ns and preferably between 0.1 ns and 10 ns.

### 2^{nd} embodiment:

In another embodiment illustrated in **Fig. 4****,** a combined semiconductor layer 40bis is disposed at one end of the MTJ 10 in contact with the free layer 23. For this embodiment the combined semiconductor layer 40bis is chosen to combine the properties of layer SOT current line 30 and the semiconductor layer 40 *i.e.* to generate a spin current and having its resistance modulated by the electrostatic gate 50. When the charge current 301 is flowing through the combined semiconductor layer 40bis, a spin current is generated by spin orbit interaction for example by spin Hall effect and/or Rashba-Edelstein effect. This pure spin current flow through the free layer 23 and is able to switch the magnetization.

The combined semiconductor layer 40bis can be a semiconductor with a large spin orbit coupling or a topological insulator such as: CdTe,HgTe, CdTe, AiSb InAs, GaSb, AlSb, Bi₁₋ₓSbₓ,Sb,Bi₂Se₃, Bi₂Te₃, Cb₂Te₃, Bi₂Te₂Se, (Bi,Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.12}Se, Bi bilayer, Ag₂Te, SmB₆, Bi₁₄Rh₃I₉, RBiPt (R=Lu, Dy, Gd,), Nd₂(Ir₁₋ₓRhₓ)₂O₇, WTe₂, MoTe₂, TaAs, HgTe, Y₂Ir₂O₇, HgCr₂Se, Hg_{1-x-y}CdₓMnyTe, TaP, NbAs, NbP, Na₃Bi, Cd₃As₂, ZrTe₅, Na₃Bi, Cd₃As₂, WₓMo₁₋ₓTe₂, LnPtBi, GdPtBi, NdPtBi, XCo₂Z (X=V, Zr, Nb, Ti, Hf, Z=Si, Ge, Sn), KHgSb, CuMnAs, Mn₃Sn, Mn₃Ge, ZrSiS, LaAIGe.

The resistance of this layer can be changed by an electrostatic gate 50 positioned below the combined semiconductor layer 40bis at a distance comprising between 0.1 nm and 100 nm and preferably between 1 nm and 20 nm due to the presence of the insulating layer 60. The electrostatic gate can be realized in a metallic material such as: Au, Cu, Ag, Pb, Zn, Ta, Mo, Pt, Pd, Si, Co, Fe, Ni or any alloy.

The combined semiconductor layer 40bis and the electrostatic gate 50 are electrically insulated from each other by an insulating layer 60. The electrical isolation can be done by any insulating material and particularly dielectric material with a high dielectric constant (high-k) such as any materials from the list: HfSiO₄, ZrSiO₄, HfO₂, ZrO₂, SiO₂, Al₂O₃.

The electrostatic gate is electrically connected to a voltage generator V_{G}. The voltage source is configured to generate an electric field E_{G} able to change the Fermi level inside the semiconductor layer 40bis. The Fermi level of the semiconductor layer will change and as well as the number of charge carrier. By this mean the resistance can be modulated. During the reading process the semiconductor layer 40bis can exhibit a low resistance. The resistance difference between the writing and the reading can be more than 50%. Decreasing the resistance during allow a more accurate reading of the memory state for a given time.

The bias voltage V_{G} should be such that the electric field E_{G} is between 0.1kV/cm and 1MV/cm and preferably between 1 kV/cm and 100 kV/cm or between 5 and 20 kV/cm.

The bias voltage V_{G} can be set to a fixed value for example applied during a duration being equal or greater than the duration of the passing writing current 301 and/or reading current 302. For example, the duration of the current pulses can be between 0.01 ns and 100 ns and preferably between 0.1 ns and 10 ns.

### 3^{rd} embodiment:

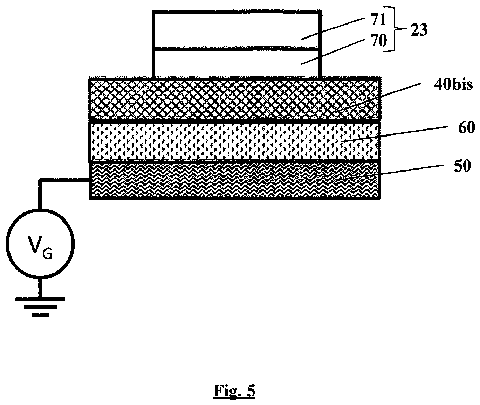

**Fig. 5** represents a partial view of the magnetic memory element 100 showing the electrostatic gate 50, the combined semiconductor layer 40bis and the free layer 23. In this figure the free layer 23 is composed by two layers having the same magnetization orientation. This magnetization can be parallel or anti-parallel to the magnetization of the reference layer 21 not represented here. The layer 70 is an insulating ferromagnetic free layer and the layer 71 is a ferromagnetic free layer.

The first layer 70 is disposed between the semiconductor layer 40bis and the second layer 71. For instance, the first layer 70 materials is an insulating ferromagnetic such as EuS, EuO, YIG, TmlG or GaMnAs. The second layer 71 is a ferromagnetic material such as any material from the list: FePt, FePd, CoPt, a rare earth/transition metal alloy, such as GdCo, TdFeCo, Co, Fe, CoFe, Ni, CoNi, CoFeB, FeB, or magnetic Heusler alloys such as CoFeAISi, Co₂FeSi, CoFeCrAl, Co₂MnSi or other suitable ferromagnetic material. The thickness of the first layer 70 and of the second layer 71 can lie between one monolayer and 10 nm, preferably between 1 and 3 nm.

Other variations to the disclosed embodiments can be understood and effected by those skilled in the art in practicing the claimed invention, from a study of the drawings, the disclosure, and the appended claims.

In particular, in all presented embodiments, the stack of layers may be reversed, i.e. by having the SOT current layer 30 on top of the free layer.

### Reference numbers and symbols

- 10: MTJ element
- 100: MRAM cell
- 21: reference layer
- 22: tunnel barrier layer
- 23: free layer
- 24: capping layer
- 30: SOT current line
- 40: semiconductor layer
- 40bis: semiconductor layer
- 50: electrostatic gate
- 301: write current
- 302: read current
- 70: Insulating ferromagnetic free layer
- 71: ferromagnetic free layer

## Claims

1. A magnetic random access memory (MRAM) cell (100), comprising:
a first magnetic tunnel junction (MTJ) element (10) comprising a tunnel barrier layer (22) between a reference layer (21) having a reference magnetization and a free layer (23) having a free magnetization that can be freely oriented, the reference and free layers (21, 23) having a perpendicular magnetic anisotropy (PMA);
the reference layer (21) and the free layer (23) are made of ferromagnetic materials;
a SOT current layer (30) configured to pass a write current (301) and generating a spin current by SOT when the write current (31) is passed, said layer is adapted for switching the free magnetization by a spin current by SOT interaction;
**characterized in that**
the MRAM cell (100) further comprises an electrostatic gate (50) separated to the semiconductor layer (40) by an insulating layer (60).

2. The MRAM cell according to claim 1, wherein the electrostatic gate (50) is connected to a voltage generator and receives a bias voltage (V_{G}).

3. The MRAM cell according to any one of claims 1 and 2,
wherein the insulating layer (60) comprises dielectric material selected among HfSiO₄, ZrSiO₄, HfO₂, ZrO₂, SiO₂, Al₂O₃.

4. The MRAM cell according to any one of claims 1 to 3,
wherein the electrostatic gate (50) comprises a metallic layer selected among any of Au, Cu, Ag, Pb, Zn, Ta, Mo, Pt, Pd, Si, Co, Fe, Ni or any alloy.

5. The MRAM cell according to any one of claims 1 to 4,
wherein the semiconductor layer (40) is between the SOT current layer (30) and the ferromagnetic layer (23).

6. The MRAM cell according to any one of claims 1 to 5,
wherein the semiconductor layer (40) realized in silicon carbide, gallium arsenic, gallium phosphide, indium phosphide, indium arsenide, and/or indium antimonide; an alloy semiconductor including SiGe, GaAsP, AlInAs, AlGaAs, GaInAs, GalnP, and/or GaInAsP; or combinations thereof or a 2D material such as graphene, WSe2, WeSe2.

7. The MRAM cell according to any one of claims 1 to 6,
wherein the combined semiconductor layer (40bis) is in direct contact of the free layer (23) on one side and in direct contact of the insulating layer (60) on the opposite side.

8. The MRAM cell according to the claim 7,
wherein the combined semiconductor layer (40bis) comprises a semiconductor layer with a large spin orbit coupling or a topological insulator adapted for switching the free magnetization by a spin current by SOT interaction.

9. The MRAM cell according to any one of claims 7 to 8,
wherein the free layer (23) comprises a first layer (70) made of insulating ferromagnetic material and a second layer (71) made of conductive ferromagnetic material, the first layer (70) being disposed between the semiconductor layer (40bis) and the second layer (71).

10. Method for performing a write operation in the magnetic memory element (1) according to any one of claims 1 to 9, comprising:
biasing the semiconductor (40) layer with a bias voltage (V_{G}) to increase the resistance then passing the writing current (301) in the SOT current layer (30) to deterministically switch the free layer magnetization.

11. Method for performing a read operation in the magnetic memory element (1) according to any one of claims 1 to 9, comprising:
biasing the semiconductor (40) layer with a bias voltage (V_{G}) to decrease the resistance then passing the read current (302) in the semiconductor layer (30) to determine the state of resistance.
